**Europäisches Patentamt**

**European Patent Office**

**Office européen des brevets**

(11) Veröffentlichungsnummer: **0 045 075**
**B1**

(12) **EUROPÄISCHE PATENTSCHRIFT**

(45) Veröffentlichungstag der Patentschrift:
06.11.85

(51) Int. Cl.⁴: **H 03 M 7/50**

(21) Anmeldenummer: **81105881.7**

(22) Anmeldetag: **24.07.81**

(54) **Verfahren zur Umwandlung von linear codierten digitalen Signalen in nichtlinear codierte digitale Signale gemäss einer dem A-Gesetz gehorchenden Mehrfachsegmentkennlinie.**

(30) Priorität: **29.07.80 DE 3028734**

(43) Veröffentlichungstag der Anmeldung:
**03.02.82 Patentblatt 82/5**

(45) Bekanntmachung des Hinweises auf die Patenterteilung:
**06.11.85 Patentblatt 85/45**

(84) Benannte Vertragsstaaten:
**AT CH FR GB IT LI NL SE**

(56) Entgegenhaltungen:
**DE - A - 2 801 988**
**DE - A - 2 830 924**
**DE - A - 2 900 586**
**DE - A - 2 900 844**
**DE - A - 2 906 156**
**DE - A - 2 938 984**
**JP - B - 54 044 861**
**US - A - 3 863 248**

(73) Patentinhaber: **Siemens Aktiengesellschaft, Berlin und München Wittelsbacherplatz 2, D-8000 München 2 (DE)**

(72) Erfinder: **Zeiträg, Rolf, Dipl.-Phys., Dompfaffweg 3, D-8000 München 82 (DE)**

## Beschreibung

Die Erfindung betrifft ein Verfahren der in den Gattungsbegriffen der Patentansprüche beschriebenen Art.

Wenn durch periodische Abtastung gewonnene Abtastproben analoger Signale in Digital-Signale in Form von PCM-Worten umgewandelt werden, erfolgt eine Zuordnung der aus einem unbegrenzten Wertevorrat sich zusammensetzenden Analogwerte wegen der begrenzten Anzahl von verwendeten Codierungselementen zu einer begrenzten Anzahl von Amplitudenstufen. Es findet also eine Quantisierung statt, als deren Folge sich ein Quantisierungsrauschen ergibt. Um sicherzustellen, dass dieses Quantisierungsrauschen nicht als Störung empfunden wird, muss bei der Rückwandlung in Analogsignale ein bestimmtes Verhältnis von Analogsignalamplitude zu der quantisierungsbedingten Störamplitude eingehalten sein.

Bei der Verwendung von 8000 Amplitudenstufen, die gleichmässig über den gesamten Amplitudenbereich der Analog-Signale verteilt sind, würde ein solches ausreichendes Nutz-Störverhältnis erreicht sein. Es müssten dann allerdings Digitalsignale übertragen werden, die wenigstens 13 Codezeichenelemente aufweisen. Ausserdem wäre bei einer solchen gleichmässigen Stufenverteilung der Störabstand im Bereich der grossen Analogwertamplituden unnötig gross. Im Zuge der Codierung der Analogwerte wird daher eine Kompandierung vorgenommen, d.h. eine Umwandlung von linearer Codedarstellung in nichtlineare Codedarstellung derart, dass das Nutz-Störverhältnis über den gesamten Amplitudenbereich etwa konstant ist. Ein genau konstantes Signal-Stör-Verhältnis ergibt sich mit einer logarithmischen Kompandierungskennlinie. Eine der Praxis oft zugrunde gelegte Kompandierungskennlinie gehorcht dem sogenannten A-Gesetz und ist aus 13 geradlinigen Segmenten zusammengesetzt. Die Steigung der Geraden dieser Kennlinie nimmt in jeder der beiden Halbebenen von Segment zu Segment um den Faktor 2 ab. Jedes Segment wiederum ist in 16 gleichgrosse Quantisierungsfächer unterteilt, deren Höhe jeweils um den Faktor 2 von Segment zu Segment anwächst. Diese Gesetzmässigkeit ist im ersten Segment unterbrochen, da dieses 32 positive und 32 negative Quantisierungsfächer enthält, die jeweils zwei Werte der linear codierten Information umfassen. Damit stehen bei einer dem A-Gesetz gehorchenden Kompandierungskennlinie 8192 Schritte in linearer Codedarstellung 256 Schritte in kompandierter Darstellung gegenüber.

Wenn man die erwähnte Zuordnung von linear codierten Signalwerten zu nicht linear codierten Signalwerten mit Hilfe eines Speichers vornimmt, dann sind $2^{13}$ Adressen notwendig, um die 256 möglichen nichtlinear codierten Signalwerte anzusteuern. Das bedeutet wegen der acht Bits, die zur nichtlinearen Codedarstellung erforderlich sind, eine Speicherkapazität von $2^{16}$ bzw. 64 kBit.

Eine Verringerung von Speicherkapazität und Anschlusszahl lässt sich dadurch erreichen, dass mehr als ein Zuordnungsspeicher verwendet wird. Bei einer bekannten Anordnung dieser Art (JP-Patent 54-44861 und Patents Abstracts of Japan, Band 3, Nr. 66, 7. Juni 1979, Seite 153 E 115) sind drei solcher Zuordnungsspeicher verwendet, von denen der zweite und dritte Speicher alternativ wirksam sind, wobei deren Ausgänge miteinander verbunden sind. Eine derartige Anordnung erfordert, dass entweder eine Entkopplung der miteinander verbundenen Ausgänge vorgesehen ist, oder dass diese Ausgänge schaltungstechnisch derart ausgebildet sind, dass die im Ruhezustand von ihnen gelieferten Ausgangspotentiale von den dem Binärwert Null entsprechenden Ausgangssignalen unterschieden werden können (Tristate-Ausgänge).

Bei einer weiteren bekannten Anordnung zur Umwandlung linear codierter digitaler Signale in nicht linear codierte digitale Signale (US-Patent 3 863 248) wird zur Verringerung des Speicheraufwands so vorgegangen, dass eine erste Codewandlung von einem m Bits umfassenden linear codierten Codewort in ein p Bits umfassendes Codewort durch Verschiebe- und Zählprozeduren unter Verwendung eines Schieberegisters und eines Zählers vorgenommen wird, und dass erst das auf diese Weise p Bits umfassende Codewort einem Zuordnungsspeicher zugeführt wird, um in einer zweiten Codewandlung ein m Bits umfassendes nicht linear codiertes Codewort zu erzeugen. Gegenüber der Verwendung von ausschliesslich Zuordnungsspeichern hat diese Anordnung den Nachteil des grösseren Zeitaufwands bei der Codewandlung durch Verschieben der umzuwandelnden Bitkombinationen in dem genannten Schieberegister.

Weiter ist vorgeschlagen worden (EP 0 029 490 A1 = DE-A1 2 938 984), für die erwähnte Zuordnung zwei Speicher heranzuziehen, die jeweils von Teilen der linear codierten Signalwerte als Ansteueradressen angesteuert werden und von denen der eine Digitalwärter speichert, die mit ihren höchstwertigen Bits das Segment der Kennlinie angeben, auf der der betreffende linear codierte Signalwert liegt und deren übrige Bits zusammen mit den nicht als Ansteueradresse für den ersten Speicher herangezogenen niedrigstwertigen Bits des betreffenden linear codierten Signalwertes als Ansteueradresse für den zweiten Speicher dienen, in dem Bitkombinationen gespeichert sind, die die entsprechenden Stufen der Segmente der Kennlinie kennzeichnen, denen die nichtlinear codierten Signalwerte zugeordnet sind.

Der nichtlinear dargestellte Signalwert setzt sich in diesem Fall aus dem höchstwertigen Bit des umzuwandelnden linear codierten Signalwertes, aus der aus dem ersten Speicher ausgelesenen Segmentadresse und aus einer aus dem zweiten Speicher ausgelesenen Stufenadresse innerhalb eines solchen Segmentes zusammen.

Auf diese Art und Weise lässt sich der vorerwähnte Speicherplatzbedarf von 64 kBit bei Verwendung eines einzigen Zuordnungsspeichers auf drei kBit reduzieren. Für die Vertragsstaaten FR, GB und SE gehört der Inhalt der früheren europäischen Patentanmeldung EP 0 029 490 A1 nach Artikel 54(3)(4) zum Stand der Technik (Patentanspruch B).

Die auf solche Weise umzuwandelnden linear codiert dargestellten Signalwerte können das Ergebnis einer Rechenoperation sein, beispielsweise bei einem Fernsprechsystem, in dem Konferenzverbindungen möglich sind, die Summen bzw. Differenzen von Signalwerten, die von den einzelnen Konferenzteilnehmern geliefert werden.

Aufgabe der vorliegenden Erfindung ist es daher, ein Verfahren anzugeben, das bei entsprechend geringem Speicherplatzaufwand, wie bei dem vorhin erwähnten vorgeschlagenen Verfahren, eine Umwandlung dieser linear codierten digitalen Signale sowie deren Zweierkomplement, beispielsweise bei Rechenoperationen von Konferenzschaltungen, gestattet.

Erfindungsgemäss wird dies durch ein Verfahren gelöst, das durch den Patentanspruch 1A für die Vertragsstaaten AT, CH, IT, LI, NL und Patentanspruch 1B für die Vertragsstaaten FR, GB, SE gekennzeichnet ist.

Wie vorstehend angegeben, soll das erfindungsgemässe Verfahren vorzugsweise bei Konferenzschaltungen zur Anwendung kommen. Bei bestimmten Rechenoperationen kann es vorteilhaft sein, die negativen linear codierten Signalwerte, die sich von den entsprechenden positiven Signalwerten lediglich dadurch unterscheiden, dass das mit V bzw. $2^{12}$ bezeichnete Bit den anderen Binärwert aufweist, durch das Zweierkomplement darzustellen. Das Zweierkomplement ist im Dualsystem, dem die hier vorliegenden Codekombinationen angehören, eine Codekombination, die die Ergänzung zur nächsthöheren Potenz von 2 darstellt. Liegt beispielsweise eine vierstellige Codekombination 1111 vor, die die Basispotenzen $2^0$ bis $2^3$ umfasst und der Dezimalzahl 15 entspricht, so stellt deren Zweierkomplement die Ergänzung zur nächsthöheren Basispotenz $2^4$ dar, also die Ergänzung zu der Dualzahl 10000. Diese ergänzende Dualzahl hat die Codekombination 0001, die der Dezimalzahl 1 entspricht.

Eine Subtraktion kann nun durch Addition des Komplements des Minuenden durchgeführt werden. Negative Differenzen stellen sich dann wieder als Zweierkomplement der Differenz dar. Solche Zweierkomplemente werden dann bei Durchführung des erfindungsgemässen Verfahrens direkt in nichtlinear codierte Codeworte umgewandelt.

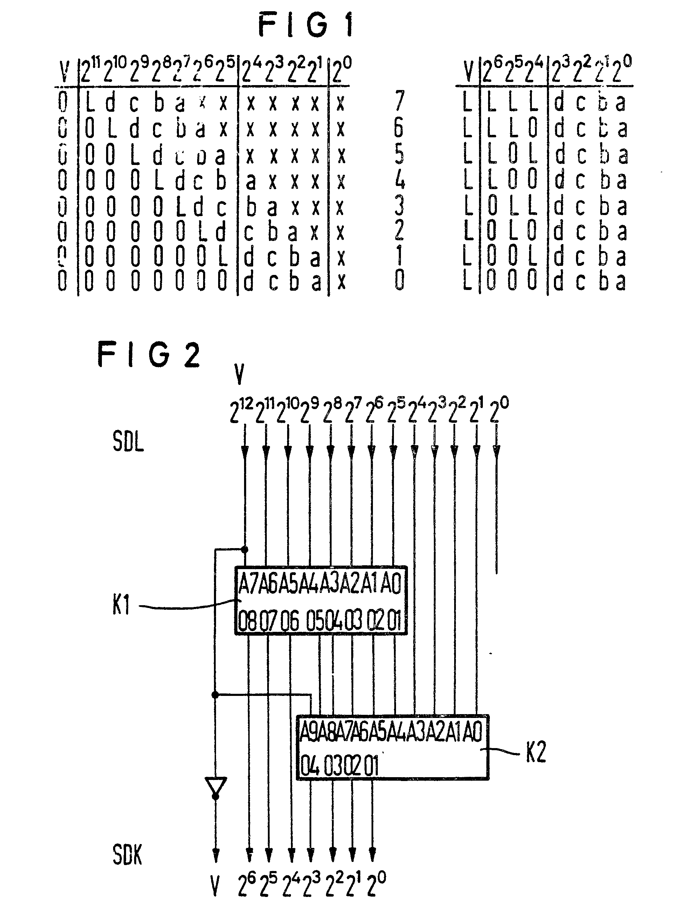

Nachstehend wird das erfindungsgemässe Verfahren anhand von zwei Figuren näher erläutert. Von den Figuren zeigen: Figur 1 die Gegenüberstellung einer Codetabelle linear codierter Signalwerte und einer Codetabelle zugeordneter nichtlinear codierter Signalwerte. Figur 2 in schematischer Darstellungsweise die Anordnung zweier Speicher und deren Ansteuer- und Ausgabeleitungen, wie sie zur Durchführung des erfindungsgemässen Verfahrens eingesetzt werden.

Die Figur 1 beschränkt sich auf die Darstellung der Verhältnisse in der positiven Hälfte einer dem A-Gesetz gehorchenden 13-Segmentkennlinie. Im linken Teil der Figur sind Bitkombinationen aus 13 Bits $2^0$ - V dargestellt, die linear codierte Signalwerte repräsentieren. Im rechten Teil der Figur sind 8 Bits $2^0$ – V umfassende Bitkombinationen dargestellt, die die entsprechenden nichtlinear codierten Signalwerte veranschaulichen. Die zwischen den beiden Codewortgruppen eingetragenen Zahlen 0 bis 7 geben an, dass die entsprechenden Zeilen die Segmente 0 bis 7 der positiven Kennlinienhälfte betreffen, wobei darauf hingewiesen sei, dass die Segmente 0 und 1 beider Kennlinienhälften jeweils dieselbe Steigung aufweisen, so dass die vollständige Kennlinie tatsächlich aus 13 Geraden zusammengesetzt ist. Wie die nichtlineare Codedarstellung im rechten Teil der Figur zeigt, sind sämtliche der Segmente 0 bis 7 in 16 gleichgrosse Stufen unterteilt, entsprechend den 16 möglichen unterschiedlichen Kombinationen a, b, c, d der vier niedrigstwertigen Bits $2^0$ bis $2^{13}$. Die drei nach dem höchstwertigen Bit $2^7$, das das Vorzeichen V angibt, niedrigerwertigen Bit $2^6$ bis $2^4$ nehmen vom Segment 0 bis zum Segment 7 die Kombinationen 000 bis LLL an und stellen die Segmentadresse dar.

Aus dem Vergleich der beiden Arten von Codedarstellungen und insbesondere derjenigen, die das Segment 0 betreffen, sieht man, dass der Binärwert des niedrigstwertigen Bits $2^0$ der linearen Codedarstellung ohne Einfluss auf die Zuordnung zu einem nichtlinear dargestellten Codewort ist, das heisst also, dass eine Stufe bei der nichtlinearen Codedarstellung wenigstens zwei linear codierte Signalwerte umfasst. Gemäss einem Teilmerkmal der Erfindung wird dieses niedrigstwertige Bit bei der Umwandlung von der einen Art der Codedarstellung in die andere unberücksichtigt gelassen. Der Vergleich der beiden Codetabellen zeigt darüber hinaus, dass im Segment 0 und im Segment 1 entsprechend den möglichen Bitkombinationen a, b, c und d jeweils 16·2 Linearschritten jeweils 16 Schritte in der nichtlinearen Codedarstellung entsprechen. Sie zeigt ferner, dass vom Segment 2 bis zum Segment 7 ansteigend die Quantisierungsfächer jeweils um den Faktor 2 grösser werden, also im Segment 2 den 16 nichtlinear codierten Codewerten jeweils 4 linear codierte Codewerte gegenüberstehen, die sich in den Kombinationsmöglichkeiten der Bits $2^0$ und $2^1$ unterscheiden, im Segment 3 den 16 nichtlinear codierten Codewerten jeweils acht linear codierte Codewerte gegenüberstehen, die sich durch die Kombinationsmöglichkeiten der Bits $2^0$ bis $2^2$ unterscheiden usw. usw. im Segment 7 den 16 nicht linear dargestellten Codewerten jeweils 128 linear codierte Codewerte entsprechend den Kombinationsmöglichkeiten der Bits $2^0$ bis $2^6$ gegenüberstehen.

Die Anordnung gemäss Figur 2 zur Durchführung des erfindungsgemässen Verfahrens weist zwei Speicher K1 und K2 auf, bei denen es sich um Festwertspeicher (ROM) handelt. Dem Speicher K1 wird das Vorzeichenbit V bzw. $2^{12}$ sowie so viele darauffolgende höherwertige Bits linear codierter Signale SDL zugeführt, wie zur Kennzeichnung des Segments der Kennlinie erforderlich sind, in das der betreffende Signalwert fällt. Es sind dies, wie die Figur 1 zeigt, die Bits $2^{11}$ bis $2^5$, da nur unter Einbeziehung aller dieser Bits festgestellt werden kann, welche Lage die in den einzelnen Segmenten die Stufengrenzen angebenden Bits a, b, c, d einnehmen, die abgesehen von den Segmenten 0 und 1, von Segment zu Segment anderswertige Bits $2^1$ bis $2^{10}$ umfassen.

Der Festwertspeicher K1 weist demnach $2^8 = 256$ Speicherzellen auf. In diesen Speicherzellen sind in entsprechender Zuordnung Digitalwörter gespeichert, deren drei höchstwertige Bits die auf das Vorzeichenbit folgenden höchstwertigen Bits des entsprechenden nichtlinear codierten Informationswertes sind, die, wie vorstehend erläutert, das Segment der Kennlinie angeben, auf der dieser Informationswert liegt. Die übrigen Bits der erwähnten im Speicher K1 gespeicherten Digitalwörter, hier 5, bilden eine Teiladresse zur Ansteuerung des zweiten Speichers K2. Die erwähnten Speicherzellen des ersten programmierbaren Speichers K1 benötigen daher Speicherplatz für jeweils 8 Bits, so dass das gesamte Speichervolumen 2048 Bits beträgt.

Die erwähnten, aus dem ersten programmierbaren Speicher K1 auslesbaren Teiladressen für den zweiten programmierbaren Speicher K2 stellen einen höherwertigen Teil dessen Ansteueradressen dar. Als niedrigerwertiger Teil dessen Ansteueradressen dienen die verbleibenden Bits, ausser dem niedrigstwertigen Bit, der linear codierten Signale, also die Bits $2^1$ bis $2^4$. Hinzu kommt als höchstwertiges Bit der Ansteueradresse für den Speicher K2 das Vorzeichenbit V der linear codierten Signalwerte SDL. Mit diesen 10 Bits umfassenden Ansteueradressen können die 1024 Speicherzellen des zweiten programmierbaren Speichers K2 angesteuert werden. Sie enthalten Bitkombinationen, die die entsprechenden Stufen der Segmente der Kennlinie kennzeichnen, in denen die einzelnen nichtlinear codierten Signalwerte liegen. Da hierzu vier Bits erforderlich sind, beträgt das Speichervolumen des zweiten programmierbaren Speichers K2 $1024 \cdot 4 = 4096$ Bit.

Wie die Figur 2 ferner zeigt, werden zur Bildung der nichtlinear codierten digitalen Signale SDK das Vorzeichenbit V der linear codierten Signale SDL als höchstwertiges Bit und damit als Vorzeichenbit V, die drei vorerwähnten aus dem ersten programmierbaren Speicher K1 auslesbaren Bits als Bits $2^6$ bis $2^4$ der nachfolgenden Wertigkeit und damit als Segmentadresse darstellende Bits und schliesslich die vier aus dem zweiten programmierbaren Speicher K2 auslesbaren Bits als niedrigstwertige Bits $2^3$ bis $2^0$ herangezogen. Das niedrigstwertige Bit $2^0$ der linear codierten digitalen Signale bleibt aus den obenerwähnten Gründen unberücksichtigt.

Die Einträge in den Speichern K1 und K2 können auch derart sein, dass die nichtlinear codierten Signalwerte im sogenannte NININI-Code erscheinen, der sich vom vorerwähnten Code dadurch unterscheidet, dass dessen höchstwertiges Bit unverändert bleibt, das in der Wertigkeit nachfolgende Bit invertiert ist, das darauffolgende Bit wieder nicht invertiert ist usw. usw.

**Patentanspruch für die Vertragsstaaten AT, CH, IT, LI, NL**

Verfahren zur Umwandlung von linear codierten digitalen Signale in nichtlinear codierte digitale Signale gemäss einer dem A-Gesetz gehorchenden Mehrfachsegmentkennlinie durch Zuordnung der in den beiden Codierungsarten codierten Signalwerte unter Zuhilfenahme von mehr als einem Zuordnungsspeicher, dadurch gekennzeichnet, dass linear codierte digitale Signale sowie deren Zweierkomplement in nichtlinear codierte digitale Signale umgewandelt werden, dass dazu zwei solche Speicher (K1, K2) verwendet werden, von denen dem ersten (K1) jeweils das höchstwertige, das Vorzeichen bestimmende Bit ($2^{12}$), sowie so viele darauffolgende höherwertige Bits ($2^{11}$ bis $2^5$) eines linear codierten Signalwertes (SDL) als Ansteueradresse zugeführt werden, wie zur Kennzeichnung des Segmentes der Kennlinie und der Lage der Stufengrenzen in dem Segment, in das der betreffende Signalwert fällt, erforderlich sind, wobei in den Speicherzellen dieses ersten Speichers (K1) Digitalwörter gespeichert sind, deren drei höchstwertige Bits (08 bis 06) die auf das Vorzeichenbit (V, $2^7$) folgenden höchstwertigen Bits ($2^6$ bis $2^4$) des entsprechenden nichtlinear codierten Signalwertes (SDK) sind, die das Segment der Kennlinie angeben, auf dem dieser Signalwert liegt und deren übrige Bits (05 bis 01) eine höherwertige Teiladresse (A8 bis A4) zur Ansteuerung des zweiten Speichers (K2) darstellen, dem als höchstwertiges Ansteueradressenbit (A9) das höchstwertige Bit (V) des jeweiligen linear codierten Signalwertes (SDL) und dem als niedrigstwertiger Ansteueradressenteil (A3 bis A0) die verbleibenden Bits ($2^1$ bis $2^4$) ausser dem niedrigstwertigen Bit ($2^0$), das bei der Umwandlung unberücksichtigt bleibt, des jeweiligen linear codierten Signalwertes (SDL) zugeführt werden, wobei in den Speicherzellen dieses zweiten Speichers (K2) die Bitkombinationen (04 bis 01) gespeichert sind, die die entsprechenden Stufen der Segmente der Kennlinie kennzeichnen, denen die nichtlinear codierten Signalwerte (SDK) zugeordnet sind, und dass zur Bildung der nichtlinear codierten Signalwerte (SDK) das invertierte höchstwertige Bit (V, $2^{12}$) der linear codierten Signalwerte (SDL), die aus dem ersten Speicher (K1) ausgelesenen erwähnten drei höchstwertigen Bits (08 bis 06) als in der Wertigkeit nachfolgende Bits ($2^6$ bis $2^4$) und die aus dem zweiten Speicher (K2) ausgelesenen Bits (04 bis 01) als niedrigstwertige Bits ($2^3$ bis $2^0$) herangezogen werden.

## Patentanspruch für die Vertragsstaaten FR, GB und SE

Verfahren zur Umwandlung von linear codierten digitalen Signalen in nichtlinear codierte digitale Signale gemäss einer dem A-Gesetz gehorchenden Mehrfachsegmentkennlinie durch die Zuordnung der in den beiden Codierungsarten codierten Signalwerte unter Zuhilfenahme von zwei Speichern (K1, K2), von denen dem ersten (K1) so viele höherwertige Bits ($2^{11}$ bis $2^5$) eines linear codierten Signalwertes (SDL) als Ansteueradresse zugeführt werden, wie zur Kennzeichnung des Segmentes der Kennlinie und der Lage der Stufengrenzen in dem Segment, in das der betreffende Signalwert fällt, erforderlich sind, wobei in den Speicherzellen dieses ersten Speichers (K1) Digitalwörter gespeichert sind, deren drei höchstwertige Bits (08 bis 06) die auf das Vorzeichenbit (V, $2^7$) folgenden höchstwertigen Bits ($2^6$ bis $2^4$) des entsprechenden nichtlinear codierten Signalwertes (SDK) sind, die das Segment der Kennlinie angeben, auf dem dieser Signalwert liegt und deren übrige Bits (05 bis 01) eine höherwertige Teiladresse zur Ansteuerung des zweiten Speichers (K2) darstellen, dem als niedrigstwertiger Ansteueradressenteil (A3 bis A0) die verbleibenden Bits ($2^1$ bis $2^4$) ausser dem niedrigstwertigen Bit ($2^0$), das bei der Umwandlung unberücksichtigt bleibt, des jeweiligen linear codierten Signalwertes (SDL) zugeführt werden, wobei in den Speicherzellen dieses zweiten Speichers (K2) die Bitkombinationen (04 bis 01) gespeichert sind, die die entsprechenden Stufen der Segmente der Kennlinie kennzeichnen, denen die nichtlinear codierten Signalwerte (SDK) zugeordnet sind, wobei zur Bildung der nichtlinear codierten Signalwerte (SDK) die aus dem ersten Speicher (K1) ausgelesenen erwähnten drei höchstwertigen Bits (08 bis 06) als in der Wertigkeit nachfolgende Bits ($2^6$ bis $2^4$) und die aus dem zweiten Speicher (K2) ausgelesenen Bits (04 bis 01) als niedrigstwertige Bits ($2^3$ bis $2^0$) herangezogen werden, dadurch gekennzeichnet, dass linear codierte digitale Signale sowie deren Zweierkomplement in nichtlinear codierte digitale Signale umgewandelt werden, dass dazu dem ersten und dem zweiten Speicher das höchstwertige, das Vorzeichen bestimmende Bit ($2^{12}$) des jeweiligen linear codierten Signalwertes (SDL) als höchstwertiges Ansteueradressenbit zugeführt wird, und dass zur weiteren Bildung der nichtlinear codierten Signalwerte (SDK) das invertierte höchstwertige Bit (V, $2^{12}$) der linear codierten Signalwerte (SDL) herangezogen wird.

## Claim for the contracting states AT CH IT LI NL

A method of converting digital signals, coded in linear fashion, into digital signals coded in non-linear fashion, in accordance with a multiple segment curve which obeys the A-law, by the assignment of signal values which are coded in both types of code, with the assistance of more than one assignment store, characterised in that linear-coded digital signals and the two's complement thereof are converted into digital signals coded in non-linear fashion, that for this purpose two such stores (K1, K2) are used, of which the first store (K1) is supplied, by way of drive address, with the highest-value bit ($2^{12}$) which determines the sign, and with as many consecutive higher-value bits ($2^{11}$ to $2^5$) of a linear-coded signal value (SDL) as are required to characterise the segment of the curve and the position of the stage boundaries in the segment within which the signal value in question falls, where the storage cells of this first store (K1) store digital words whose three highest-value bits (08 to 06) are the highest-value bits ($2^6$ to $2^4$), which follow the sign bit (V, $2^7$), of the corresponding non-linear-coded signal value (SDK) which indicate that segment of the curve on which this signal value lies and whose other bits (05 to 01) represent a higher-value sub-address (A8 to A4) for driving the second store (K2) which, by way of highest-value drive address bit (A9), is supplied with the highest-value bit (V) of the relevant linear-coded signal value (SDL), and which, by way of lowest-value drive address component (A3 to A0), is supplied with the remaining bits ($2^1$ to $2^4$) apart from the lowest-value bit ($2^0$), which is disregarded in the conversion, of the linear-coded signal value (SDL) in question, where the storage cells of this second store (K2) store the bit combinations (04 to 01) which characterise the corresponding stages of the segments of the curve which are assigned the non-linear-coded signal values (SDK), and that the non-linear-coded signal values (SDK) are formed by the inverted highest-value bit (V, $2^{12}$) of the linear-coded signal values (SDL), the aforementioned three highest-value bits (08 to 06), which have been read out from the first store K1, as bits ($2^6$ to $2^4$) which follow in value, and the bits (04 to 01), which have been read out from the second store (K2), as lowest-value bits ($2^3$ to $2^0$).

## Claim for the contracting states FR GB SE

A method of converting digital signals, coded in linear fashion, into digital signals coded in non-linear fashion, in accordance with a multiple segment curve which obeys the A-law by the assignment of signal values which are coded in both types of code, with the assistance of two stores (K1, K2) of which the first (K1) is supplied, by way of drive address, with as many higher-value bits ($2^{11}$ to $2^5$) of a linear coded signal value (SDL) as are needed to characterise the segment of the curve and the position of the stage boundaries in the segment into which the signal value in question falls, where the storage cells of this first store (K1) store digital words whose three highest-value bits (08 to 06) are the highest-value bits ($2^6$ to $2^4$), which follow the sign bit (V, $2^7$), of the corresponding non-linear-coded signal value (SDK) which indicate that segment of the curve on which this signal value lies and whose other bits (05 to 01) represent a higher-value sub-address for driving the second store (K2) which, by way of lowest-value drive address component (A3 to A0), is supplied with the remaining bits ($2^1$ to $2^4$) apart from the lowest-value bit ($2^0$), which is disregarded during the conversion, of the linear-coded signal value (SDL) in question, where the storage cells of this second store (K2) store the bit combinations (04 to 01) which characterise the corresponding stages of those segments of the curve to which the non-linear-coded signal values (SDK) are assigned, where, in order to form the non-linear-coded signal values (SDK), the aforementioned three highest-value bits (08 to 06) which are read-out from the first store (K1) are used as the bits ($2^6$ to $2^4$) which follow in value, whereas the bits (04 to 01) which are read-out from the second store (K2) are used as the lowest-value bits ($2^3$ to $2^0$), characterised in that linear-coded digital signals, and their two's complement are converted into non-linear-coded digital signals, that for this purpose the first and the second stores are supplied, by way of highest-value drive address bit, with the highest-value bit ($2^{12}$), which determines the sign of the linear-coded signal value (SDL) in question, and that the inverted highest-value bit (V, $2^{12}$) of the linear-coded signal values (SDL) are used for the further formation of the non-linear-coded signal values (SDK).

**Revendication pour les Etats contractants
AT CH IT LI NL**

Procédé pour convertir des signaux numériques codés linéairement en signaux numériques codés non linéairement selon une courbe caractéristique à segments multiples répondant à la loi A, par association des valeurs de signaux codées selon les deux types de codage, avec mise en œuvre de plus d'une mémoire d'association, caractérisé par le fait que des signaux numériques codés linéairement ainsi que leur complément à deux sont convertis en des signaux numériques codés non linéairement, qu'à cet effet on utilise deux mémoires (K1, K2) à la première (K1) desquelles on applique comme adresse de commande, le nombre de bits de poids élevé ($2^{11}$ à $2^5$) d'une valeur de signal (SDL) codée linéairement, qui sont nécessaires pour caractériser le segment de la courbe caractéristique et la position des limites des échelons dans le segment dans lequel se situe la valeur de signal considérée, que dans les cellules de mémorisation de cette première mémoire (K1) se trouvent mémorisés des mots numériques, dont les trois bits de poids les plus élevés (08 à 06) sont les bits de poids les plus élevés ($2^6$ à $2^4$) de la valeur de signal correspondante (SDK) non codée linéairement, qui suivent le bit de signe (V, $2^7$) et qui indiquent le segment de la courbe caractéristique sur lequel se situe cette valeur de signal, et dont les autres bits (05 à 01) représentent une adresse partielle de poids élevé (A8 à A4) pour la commande de la seconde mémoire (K2), à laquelle le bit de poids le plus élevé (V) de la valeur de signal correspondante (SDL) codée linéairement est envoyée en tant que bit d'adresse de commande (A9) de poids le plus élevé et à laquelle les bits restants ($2^1$ à $2^4$) sont envoyés en tant que partie d'adresse de commande (A3 à A10) de poids le plus faible, à l'exception du bit ($2^2$) de poids le plus faible, dont il n'est pas tenu compte lors de la conversion, de la valeur de signal (SDL) codée linéairement, que dans les cellules de mémorisation de cette seconde mémoire (K2) se trouvent mémorisées les combinaisons de bits (04 à 01) qui caractérisent les échelons correspondants des segments de la courbe caractéristique, auxquels sont associées les valeurs de signaux (SDK) codées non linéairement, et que pour la formation des valeurs de signaux (SDK) codées non linéairement, on utilise le bit inversé de poids le plus élevé (V, $2^{12}$) des valeurs de signaux (SDL) codées linéairement, les trois bits de poids les plus élevés (08 à 06) mentionnés, lus dans la première mémoire (K1), en tant que bits ($2^6$ à $2^4$) qui viennent ensuite du point de vue de leur poids, et les bits (04 à 01) lus dans la seconde mémoire (K2) en tant que bits de poids les plus faibles ($2^3$ à $2^0$).

**Revendication pour les Etats contractants
FR GB SE**

Procédé pour convertir des signaux numériques codés linéairement et des signaux numériques codés non linéairement selon une courbe caractéristique à segments multiples répondant à la loi A, par association des valeurs de signaux codés selon les deux types de codage, avec mise en œuvre de deux mémoires (K1, K2), à la première (K1) desquelles ou applique, comme adresse de commande, le nombre de bits de poids élevé ($2^{11}$ à $2^5$) d'une valeur de signal (SDL) codée linéairement, qui sont nécessaires pour caractériser le segment de la courbe caractéristique et la position des limites des échelons dans le segment dans lequel se situe la valeur de signal considérée, selon lequel dans les cellules de mémorisation de cette première mémoire (K1) sont mémorisés des mots numériques, dont les trois bits de poids les plus élevés (08 à 06), sont les bits de poids les plus élevés ($2^6$ à $2^4$) de la valeur de signal correspondante (SDK) non codée linéairement, qui suivent le bit de signe (V, $2^7$) et qui indiquent le segment de la courbe caractéristique sur lequel se situe cette valeur de signal, et dont les autres bits (05 à 01) représentent une adresse partielle de poids élevé pour la commande de la seconde mémoire (K2), à laquelle sont envoyés, comme partie d'adresse de commande de poids le plus faible (A3 à A0), les bits restants ($2^1$ à $2^4$), à l'exception du bit ($2^0$) de poids le plus faible, dont il n'est pas tenu compte lors de la conversion, de la valeur de signal (SDL) codée linéairement, et selon lequel dans les cellules de mémorisation de cette seconde mémoire (K2) sont mémorisées les combinaisons de bits (04 à 01) qui caractérisent les échelons correspondants des segments de la courbe caractéristique, auxquels sont asociées les valeurs de signaux (SDK) codées non linéairement, et selon lequel pour la formation des valeur de signaux (SDK), codées non linéairement, on utilise les trois bits mentionnés de poids les plus élevés (08 à 06) lus dans la première mémoire (K1) en tant que bits ($2^6$ à $2^4$), qui viennent ensuite du point de vue de leur poids, et les bits (04 à 01) lus dans la seconde mémoire (K2) en tant que bits de poids les plus faibles ($2^3$ à $2^0$), caractérisé par le fait que des signaux numériques codés linéairement ainsi que leurs compléments à deux sont convertis en signaux numériques codés non linéairement, qu'à cet effet on applique à la première et à la seconde mémoire le bit de poids le plus élevé ($2^{12}$) qui détermine le signe, de la valeur de signal (SDL) respective codée linéairement, en tant que bit d'adresse de commande de poids le plus élevé, et que pour la poursuite de la formation des valeurs de signaux (SDK) codées non linéairement, on utilise le bit inversé (V, $2^{12}$) des valeurs de signaux (SDL) codées linéairement.

# F I G 1

| V | $2^{11}$ | $2^{10}$ | $2^9$ | $2^8$ | $2^7$ | $2^6$ | $2^5$ | $2^4$ | $2^3$ | $2^2$ | $2^1$ | $2^0$ | |
|---|---|---|---|---|---|---|---|---|---|---|---|---|---|
| 0 | L | d | c | b | a | x | x | x | x | x | x | x | 7 |
| 0 | 0 | L | d | c | b | a | x | x | x | x | x | x | 6 |
| 0 | 0 | 0 | L | d | c | b | a | x | x | x | x | x | 5 |
| 0 | 0 | 0 | 0 | L | d | c | b | a | x | x | x | x | 4 |
| 0 | 0 | 0 | 0 | 0 | L | d | c | b | a | x | x | x | 3 |
| 0 | 0 | 0 | 0 | 0 | 0 | L | d | c | b | a | x | x | 2 |
| 0 | 0 | 0 | 0 | 0 | 0 | 0 | L | d | c | b | a | x | 1 |
| 0 | 0 | 0 | 0 | 0 | 0 | 0 | 0 | d | c | b | a | x | 0 |

| V | $2^6$ | $2^5$ | $2^4$ | $2^3$ | $2^2$ | $2^1$ | $2^0$ |
|---|---|---|---|---|---|---|---|
| L | L | L | L | d | c | b | a |
| L | L | L | 0 | d | c | b | a |
| L | L | 0 | L | d | c | b | a |
| L | L | 0 | 0 | d | c | b | a |
| L | 0 | L | L | d | c | b | a |
| L | 0 | L | 0 | d | c | b | a |
| L | 0 | 0 | L | d | c | b | a |
| L | 0 | 0 | 0 | d | c | b | a |

# F I G 2

V

SDL

$2^{12}$ $2^{11}$ $2^{10}$ $2^9$ $2^8$ $2^7$ $2^6$ $2^5$ $2^4$ $2^3$ $2^2$ $2^1$ $2^0$

K1

A7 A6 A5 A4 A3 A2 A1 A0
08 07 06 05 04 03 02 01

A9 A8 A7 A6 A5 A4 A3 A2 A1 A0
04 03 02 01

K2

SDK

V $2^6$ $2^5$ $2^4$ $2^3$ $2^2$ $2^1$ $2^0$